# EUROPEAN PATENT SPECIFICATION

(11) **EP 4 288 292 B1**
(45) Date of publication and mention of the grant of the patent: **09.12.2026**
(21) Application number: 22750482.6
(22) Date of filing: 04.02.2022
(51) Int. Cl.: G02B 26/08

(54) **LASER MARKING SYSTEM**
LASERMARKIERUNGSSYSTEM
SYSTEME DE MARQUAGE LASER

(30) Priority: 05.02.2021 US 202163146488 P; 04.05.2021 US 202163183789 P; 03.02.2022 US 202217591884
(43) Date of publication of application: 13.12.2023
(73) Proprietor: Silicon Light Machines Corporation, San Jose, CA 95119 (US)
(72) Inventor: JACOB, Gregory, Santa Clara, California 95051 (US); HAMANN, Stephen, Mountain View, California 94040 (US); PAYNE, Alexander, Ben Lommond, California 95005 (US); ENG, Lars, Los Altos, California 94022 (US); HUNTER, James, Campbell, California 95008 (US)
(74) Representative: AWA Sweden AB
(86) International application number: PCT/US2022/015347
(87) International publication number: WO 2022/170118

(56) References cited:
- US-A- 5 719 682
- US-A- 5 719 682
- US-A1- 2003 011 672
- US-A1- 2003 011 672
- US-A1- 2012 044 569
- US-A1- 2012 044 569
- US-A1- 2018 039 073
- US-A1- 2018 039 073
- US-A1- 2019 116 346
- US-A1- 2019 116 346
- US-A1- 2020 247 052
- US-A1- 2020 247 052
- US-A1- 2020 371 344
- US-A1- 2020 376 594

## Description

### CROSS-REFERENCE TO RELATED APPLICATIONS

This application is an International Application of U.S. Non-Provisional Application Number 17/591,884, filed on February 3, 2022, and claims the benefit of U.S. Provisional Patent Application Ser. No. 63/146,488, filed February 5, 2021, and to U.S. Provisional Patent Application Ser. No. 63/183,789, filed May 4, 2021.

### TECHNICAL FIELD

The present invention relates generally to laser marking systems, and more particularly to laser marking systems including spatial light modulators with a multi-pixel, linear array of is a microelectromechanical systems based diffractors, and methods of operating the same.

### BACKGROUND

Laser marking systems are used in a wide range of industries to create an image or mark, such as text, logos, barcodes, or two-dimensional, QR codes on a surface of parts or articles. Common methods of marking include oxidizing, annealing, etching or ablating or discoloring the surface. Advantages of laser marking include that it can be performed on a wide variety of materials, it is permanent, and does not require physical contact to mark a surface of a workpiece.

Laser marking systems typically use a single laser beam that is scanned across the surface of the workpiece using galvanometric mirrors and print one spot at a time. Thus, depending on the size and complexity or density of pixels in the mark or image, current laser marking systems can have marking times of two minutes or more to mark the surface of a single workpiece. Additionally, attempts have been made to print or mark to larger areas using laser marking systems including spatial light modulators (SLM), such as digital micro-mirror devices (DMDs), commercially available from Texas Instruments, and liquid crystal on silicon (LCOS) modulators. However, these existing SLMs cannot handle the high power lasers needed to mark larger areas than a single spot at a time.

Accordingly, there is a need for a laser marking system capable of marking a larger area than a single spot at a time to decrease marking time and increase system throughput. Additionally, there is a further need for a laser marking system capable of using higher power lasers to both decrease marking time and increase an area that can be marked at a single time.

US 2020/0247052 A1 mentions a spatial light modulator (SLM) including a two-dimensional (2D) array of n rows of m pixels, and a stacked drive circuit including at least one, one-dimensional (1D) array of n*m drivers monolithically integrated on the same substrate and methods of fabricating and methods of using the same in materials and processing applications. Generally, each pixel includes at least one modulator, and is configured to modulate light incident thereon in response to drive signals received from the stacked drive circuit. The 1D array of the stacked drive circuit includes a single row of n*m drivers arranged adjacent to and laterally separated from the 2D array of pixels.

US 5,718,682 mentions a method for printing grayscale images that compensate for problems in the printing process. The presence of a defective element on a spatial light modulator (12) is compensated for with use of a white balancing area. If a column of the modulator (12) has an element stuck ON, a corresponding element in the same column in the white balancing area is turned OFF while all other columns have elements that are ON. If the illumination is nonuniform, the exposure values of each element are multiplied by an efficiency factor which compensates for the non-uniformity.

US 2012/0044569 A1 mentions a focusing system (100) for focusing an electromagnetic beam for three-dimensional random access applications, the system comprising a first pair of acousto-optic deflectors (10) for focusing an electromagnetic beam in an X-Z plane, and a second pair of acousto-optic deflectors (20) for focusing an electromagnetic beam in a Y-Z plane being substantially perpendicular to the X-Z plane, characterised in that the second pair of acousto-optic deflectors are arranged between the acousto-optic deflectors of the first pair of acousto-optic deflectors, such that the first and fourth acousto-optic deflectors of the system belong to the first pair of acousto-optic deflectors and the second and third acousto-optic deflectors of the system belong to the second pair of acousto-optic deflectors.

US 2003/0011672 A1 mentions a technique for marking pixels on workpieces by routing a scanned beam to different marking stations to mark individual pixels on the workpieces. A diffractive scan lens focuses the beam. A mark is formed on a workpiece by producing the mark and curing the mark. Angular position of a scanning mirror in a raster scanner is determined by moving a beam, reflected from the scanner, across rulings on an optical element during scanning. A print head for printing spots on a surface of a workpiece has a walled, internally pressurized chamber and structure for causing an inked web to conform to a contour of the chamber wall and to be pulled along the chamber wall. A print head has a compliant-walled, internally pressurized chamber. A print head has a chamber having a low-coefficient of friction coating. Two workpieces may be marked at two marking stations by two-directional scanning. US 2018/0039073 A1 mentions an illustrative example device for steering radiation includes an optic component including a plurality of concave surfaces on at least one side of the optic component, a plurality of radiation sources respectively aligned with the plurality of concave surfaces, and at least one actuator that selectively moves the optic component relative to the plurality of light sources to selectively change a direction of respective beams of radiation passing through the plurality of concave surfaces.

US 2019/0116346 mentions a multi-beam scanning system and methods of operating the same to compensate for distortion. Generally, the method involves illuminating a spatial light modulator including SLM pixels arranged in parallel, each pixel including a multiple address pixels. Drive signals including image data are provided to the pixels to generate beams of modulated light reflected therefrom, which is scanned to a linear swath of a two-dimensional imaging plane using a collimate lens, a scan mirror moved about a first axis, and an imaging lens. The swath is scanned across the imaging plane in a direction orthogonal to a long axis of the swath by moving the scan mirror about a second axis. To compensate for distortion along the long axis of the swath compensated image data is provided to at least some of the address pixels generating beams of modulated light distal from an optical axis of the imaging lens.

### SUMMARY

A laser marking system with a spatial light modulator (SLM) including a multi-pixel, linear array of microelectromechanical systems (MEMS) based diffractors, and methods of operating the same are disclosed. Generally, the system includes, in addition to the SLM, a laser operable to illuminate the SLM; imaging optics operable to focus a substantially linear swath of modulated light onto a surface of a workpiece, the linear swath including light from multiple pixels of the SLM, and a controller operable to control the SLM, laser and imaging optics to mark the surface of the workpiece to record a two-dimensional image thereon.

In one embodiment, each of the MEMS based diffractors include a number of electrostatically deflectable ribbons suspended over a substrate, each ribbon having a light reflective surface. Eelectrostatic deflection of one or more of the ribbons brings light reflected from the light reflective surface of a first electrostatically deflectable ribbon into interference with light reflected from the light reflective surface of ribbons in the diffractors in same or adjacent diffractors to modulate light incident thereon.

In another embodiment, the MEMS based diffractors are two-dimensional diffractors, each including: a piston layer suspended over a surface of a substrate by posts at corners thereof, the piston layer including an electrostatically deflectable piston and a number of flexures through which the piston is coupled to the posts; a first reflective surface over a top surface of the piston; and a faceplate suspended over the piston layer, the faceplate including a second reflective surface on a top surface of the faceplate, and an aperture through which the piston exposed. Electrostatic deflection of the piston brings light reflected from the first reflective surface into interference with light reflected from the second reflective surface to modulate light incident thereon.

Further features and advantages of embodiments of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to a person skilled in the relevant art(s) based on the teachings contained herein.

### BRIEF DESCRIPTION OF THE DRAWINGS

Embodiments of the invention will now be described, by way of example only, with reference to the accompanying schematic drawings in which corresponding reference symbols indicate corresponding parts. Further, the accompanying drawings, which are incorporated herein and form part of the specification, illustrate embodiments of the present invention, and, together with the description, further serve to explain the principles of the invention and to enable a person skilled in the relevant art(s) to make and use the invention.
FIG. 1 is a block diagram of a laser marking system including a spatial light modulator (SLM);
FIGs. 2A-2C are schematic block diagrams illustrating an embodiment of a SLM including ribbon-type Microelectromechanical System (MEMS) based diffractors;
FIGs. 3A-3C are schematic block diagrams illustrating an embodiment of a SLM including MEMS based two-dimensional (2D) diffractors;
FIG. 4 is a schematic block diagram of a top view of an SLM including a multi-pixel, linear array of MEMS based 2D diffractors, such as those shown in FIGs. 3A-3C;
FIGs. 5A and 5B are schematic block diagrams of an embodiment of a laser marking system including an SLM with a multi-pixel, linear array of MEMS based diffractors, and galvanometric mirrors for scanning;
FIGs. 6A-6C are schematic block illustrating single-stripe and multi-stripe scanning using a laser marking system including an SLM with a multi-pixel, linear array of MEMS based diffractors for surface modification;
FIG. 7 is an optics diagram illustrating illumination and imaging light paths along a vertical or longitudinal axis of a linear array for a laser marking system including an SLM with a multi-pixel, linear array of MEMS based diffractors for surface modification;
FIG. 8 is a schematic block diagram of an embodiment of a laser marking system including an SLM with a multi-pixel, linear array of MEMS based diffractors, and a moving fixture or stage to which a workpiece can be affixed;
FIG. 9 is a schematic block diagram of another embodiment of a laser marking system including an SLM with a multi-pixel, linear array of MEMS based diffractors, and with focus before the galvanometric mirrors for scanning;
FIG. 10 is a flowchart of a method of modifying or marking a surface using a surface modification system including a MEMS based SLM;
FIGs. 11A through 11C are schematic block illustrating a method of modifying or marking a surface using interleaving of two or more scans of the surface; and
FIGs. 12A and 12B are schematic block diagrams two adjacent groups of eight pixels in a linear array of MEMS based 2D diffractors illustrating a pixel shaping method for recording an image with a high density pattern.

### DETAILED DESCRIPTION

A laser marking system including a spatial light modulator (SLM) with a multi-pixel, linear array of microelectromechanical systems (MEMS) based diffractors, and methods of operating the same are described herein with reference to figures.

In the following description, for purposes of explanation, numerous specific details are set forth in order to provide a thorough understanding of the present invention. It will be evident, however, to one skilled in the art that the present invention can be practiced without these specific details. In other instances, well-known structures, and techniques are not shown in detail or are shown in block diagram form in order to avoid unnecessarily obscuring an understanding of this description.

Reference in the description to "one embodiment" or "an embodiment" means that a particular feature, structure, or characteristic described in connection with the embodiment is included in at least one embodiment of the invention. The appearances of the phrase "in one embodiment" in various places in the specification do not necessarily all refer to the same embodiment. The term to couple as used herein can include both to directly electrically connect two or more components or elements and to indirectly connect through one or more intervening components.

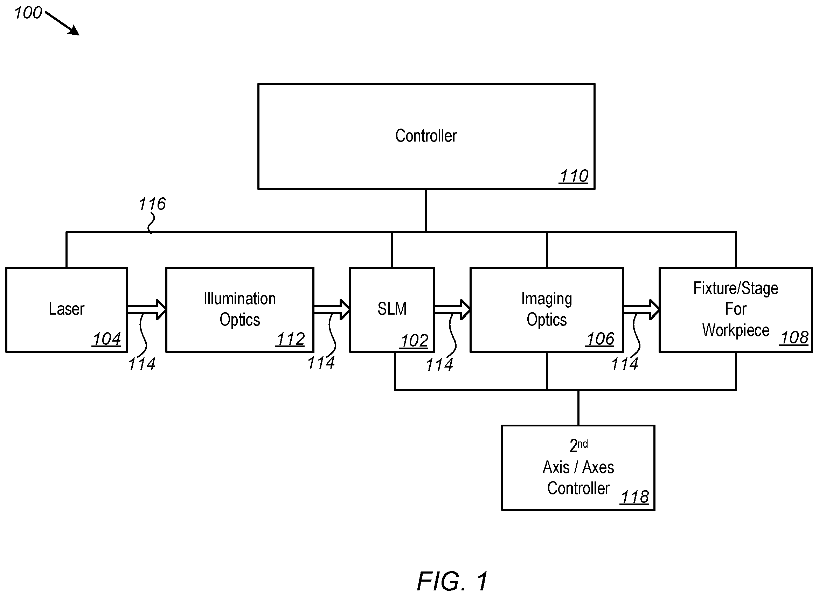

FIG. 1 is a block diagram of a laser marking system 100 including a spatial light modulator (SLM **102)** with a multi-pixel, linear array of Microelectromechanical System (MEMS) based diffractors (not shown in this figure). Briefly, the laser marking system **100** includes, in addition to the SLM **102,** a laser **104** operable to illuminate the SLM, imaging optics **106** operable to focus a substantially linear swath of modulated light onto a surface of a workpiece on fixture **108** or stage, and a controller **110** operable to control the SLM, laser and imaging optics to scan the linear swath of modulated light across the surface of the workpiece to record a two-dimensional (2D) image thereon. Generally, as in the embodiment shown, the laser marking system 100 further includes illumination optics **112** with a beam forming optical system to direct a rectangular beam onto the linear array of the SLM **102.**

Typically, the laser **104** is capable of operating in ultraviolet (UV) wavelengths of from 355 nanometers (nm) through infrared (IR) wavelengths up to about 2000 nm in either a continuous wave (CW) mode, or in a pulse mode with widths or durations of from about 1 femtoseconds (fs) up to about 500 nanoseconds (ns) at a repetition rate of from about 10 kHz up to about 300 kHz, and at energy ranges of from about 10 microjoules (µJ) up to greater than 10 millijoules (mJ). In one embodiment particularly useful for laser marking systems the laser **104** is capable of operating in visible wavelength (λ) of about 514 nm, at pulse energies of from about 200 µJ at a pulse width or duration of about 260 fs and repetition rate of 100 kHz.

As noted above, the SLM **102** includes a multi-pixel; linear array of MEMS based diffractors grouped or coupled to provide from about 10 to about 1088 individually addressable pixels. Suitable SLM **102** include those having a linear array of ribbon-type, electrostatically adjustable diffraction grating, such as a Grating Light Valve (GLV^{™}), and MEMS based two-dimensional (2D) diffractors, such as a Linear Planar Light Valve (LPLV^{™}), both of which are commercially available from Silicon Light Machines Inc., of San Jose CA, and are described in detail hereinafter.

The imaging optics **106** can include dynamic optical elements, such as galvanometric mirrors, to scan the linear swath of modulated light across the surface of the workpiece, and a number of static optical elements to direct modulated light to the galvanometric mirrors and/or to focus the modulated light from the galvanometric mirrors onto the surface of the workpiece.

The fixture **108** on which the workpiece to be marked is placed or affixed can include a static fixture, or a movable stage operable to move or reposition the workpiece relative to a substantially stationary linear swath of modulated light, to scan the linear swath of modulated light across the surface of the workpiece. In either embodiment, whether static or movable, the fixture **108** preferably includes a number of sensors and signaling means to signal other components in the laser marking system when the workpiece is in proper position to be marked. In some embodiments, described in greater detail hereinafter, the fixture **108** includes a movable stage capable of being moved along two orthogonal axes to enable scanning multiple parallel swaths to record or mark larger 2D images on the workpiece. In other embodiments, laser marking system **100** includes both imaging optics **106** with galvanometric mirrors, and a movable stage (fixture **108)** capable of being moved along a single axis orthogonal to the direction the galvanometric mirrors scan the linear swath of modulated light to record or mark larger 2D images on the workpiece.

The laser **104,** illumination optics **112,** SLM **102,** imaging optics **106** and workpiece held on the fixture **108** are optically coupled in the direction indicated by arrows **114.** Additionally, the laser **104,** illumination optics **112,** SLM **102,** imaging optics **106** and fixture **108** are electrically coupled in signal communication with the controller **110** and each other through a control bus **116.** In particular, controller **110** provides digital image data to the SLM **102,** controls a power level of the laser **104,** controls operation of galvanometric mirrors in the imaging optics **106** and controls the movable stage of the fixture **108** (where included) through the control bus **116.** Additionally, the fixture **108** can signal the controller **110,** SLM **102** and/or the laser **104** when the workpiece is in proper position to be marked, and the SLM can signal the laser when the image data loaded to the SLM is ready to be recorded on the workpiece so that the laser can be pulsed.

Optionally, as in the embodiment shown, the laser marking system **100** can further include a second axis or axes controller **118** electrically coupled in signal communication with the SLM **102,** imaging optics **106** and movable stage of the fixture **108** (where included) through a second control bus **116** control movement of the linear swath along one of two orthogonal axes.

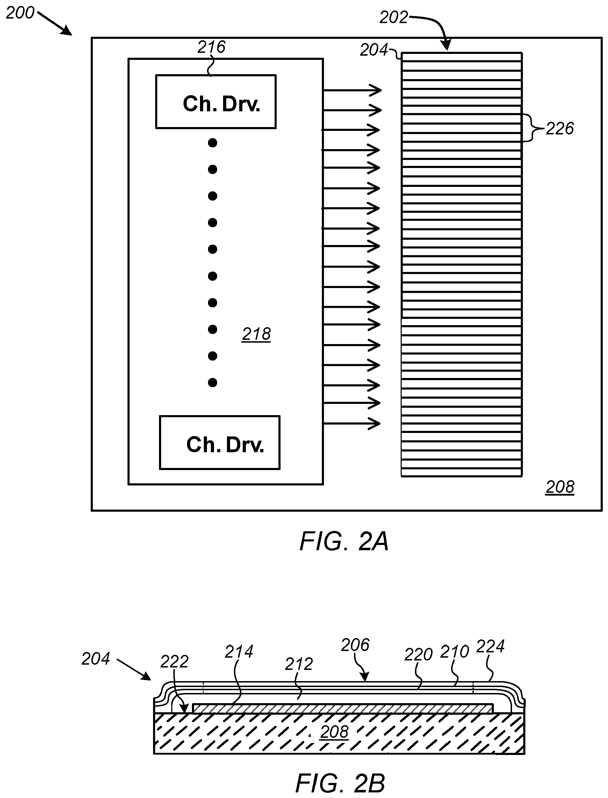

An embodiment of a SLM including a multi-pixel, linear array of MEMS based ribbon-type, electrostatically adjustable diffractors, such as a GLV^{™} will now be described with reference to FIGs. 2A through 2C. For purposes of clarity, many of the details of SLMs in general and MEMS based ribbon-type diffractors in particular that are not relevant to the present invention have been omitted from the following description. The drawings described are only schematic and are nonlimiting. In the drawings, the size of some of the elements may be exaggerated and not drawn to scale for illustrative purposes. The dimensions and the relative dimensions may not correspond to actual reductions to practice of the invention.

Referring to FIGs. 2A and 2B in the embodiment shown the SLM **200** includes a linear array **202** composed of thousands of free-standing, addressable electrostatically actuated ribbons **204,** each ribbon having a light reflective surface **206** supported over a surface of a substrate **208,** where a number of ribbons are grouped together to form the MEMS based diffractors. Each of the ribbons **204** includes an electrode **210** and is deflectable through a gap or cavity **212** toward the substrate **208** by electrostatic forces generated when a voltage is applied between the electrode **210** in the ribbon **204** and a base electrode **214** formed in or on the substrate. Each of the electrodes **210** are driven by one of a number of drive channels **216** in a driver **218,** which may be integrally formed on the same substrate **208** with the linear array **202,** as in the embodiment shown, or formed on a second substrate or chip and electrically coupled thereto (not shown).

A schematic sectional side view of a ribbon **204** of the SLM **200** of FIG. 2A is shown in FIG. 2B. Referring to FIG. 1B, the ribbon **204** includes an elastic mechanical layer **220** to support the ribbon above a surface **222** of the substrate **208,** a conducting layer or electrode **210** and a reflective layer **224** including the reflective surface **206** overlying the mechanical layer and conducting layer.

Generally, the mechanical layer **220** comprises a taut silicon-nitride film, and is flexibly supported above the surface **222** of the substrate **208** by a number of posts or structures, typically also made of silicon-nitride, at both ends of the ribbon **204.** The conducting layer or electrode **210** can be formed over and in direct physical contact with the mechanical layer **220,** as shown, or underneath the mechanical layer. The conducting layer or electrode **210** can include any suitable conducting or semiconducting material compatible with standard MEMS fabrication technologies. For example, the conducting layer used for the electrode **210** can include a doped polycrystalline silicon (poly) layer, or a metal layer. Alternatively, if the reflective layer **224** is metallic it may also serve as the electrode **210.**

The separate, discrete reflecting layer **224,** where included, can include any suitable metallic, dielectric or semiconducting material compatible with standard MEMS fabrication technologies, and capable of being patterned using standard lithographic techniques to form the reflective surface **206.**

In the embodiment shown, a number of ribbons are grouped together to form a large number of MEMS channels or pixels **226,** each driven by a much smaller number of drive channels **216.** Deflection of a ribbon **204** causes light reflected from the reflective surface **206** to constructively or destructively interfere with light reflected from the reflective surface of an adjacent ribbon, there enabling the pixel **226** to switch between an on or bright state, an off or dark state or an intermediate gray-scale. In particular, it is noted that gray-scale control of the MEMS based diffractors can provide a precise dosage of light from each pixel onto the surface of the workpiece to compensate for non-uniformities in light illuminating the SLM **200** or in modulated transmitted from the SLM to a surface of a workpiece through imaging optics.

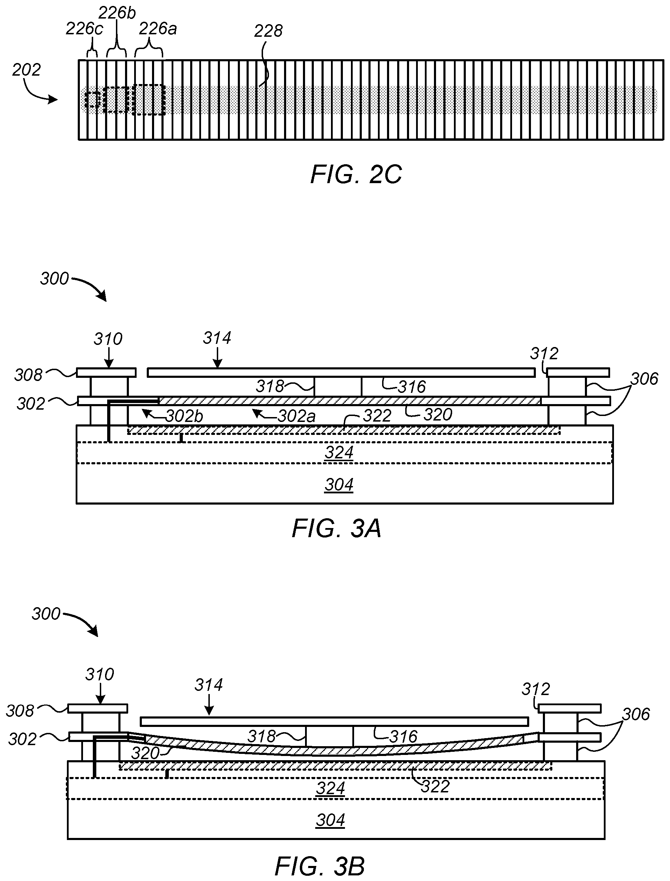

Referring to FIG. 2C in one embodiment suitable for laser marking systems, the linear array **202** includes 1088 individually addressable ribbons **204** that can be grouped together to form channels or pixels **226** having any number of ribbons depending on pixel size requirements. Additionally, the SLM can include drive channels **216** (shown in FIG. 2A) with up to 10-bit amplitude modulation to support gray-scale, and is capable of being modulated or switched at speeds up to 350 kHz. Referring again to FIG. 2C, shaded rectangle illustrates an illuminated area **228** on the linear array **202** illuminated by a rectangular beam directed onto the SLM **200.** In some embodiments for laser marking systems, it is desirable to provide pixel configurations having a square aspect ratio. For example, in the embodiment shown wherein the linear array **202** includes about ribbons **204,** each having a width of about 25 µm, and the illuminated area **228** has a width of about 75 µm, the ribbons can be grouped to form 360 square pixels **226a** each including portions of three adjacent ribbons. Alternatively, the width of the illuminated area can be reduced to about 50 µm and the ribbons **204** can be grouped to form 512 50 µm × 50 µm square pixels **226b** each including portions of two adjacent ribbons, or the width of the illuminated area can be further reduced to about 25 µm such that each ribbon forms 1088 25 µm × 25 µm square pixels **226c.**

Advantages of the ribbon-type MEMS based SLM 200 include:
a. Linear array **202** pixel counts from about 1000 to about 8000 pixels **226;**
b. Ability to modulate a wide range of laser wavelengths from 355 to 1064 nm, including about 514 nm;
c. Low mass and high tension of the ribbons **204** enable high speed switching of less than about 300ns - up to ten times faster digital micro-mirror devices (DMDs) and a thousand times faster than liquid crystal on silicon (LCOS) devices;
d. Natural Analog gray-scale control of modulated light intensity, with amplitude resolution limited only by bit-depth of drive channels **216;**
e. High power handling due to the ribbons **204** being made of silicon nitride, a robust, amorphous, high-temperature ceramic, with power densities up to and exceeding 10kW/cm²;
f. Non-contact, high reliability >10,000-hour lifetime demonstrated even under high-fluence UV illumination;
g. Borderless pixels with images being formed by spatially filtering the angularly modulated light, eliminating "screen door" effect of projected pixel images.

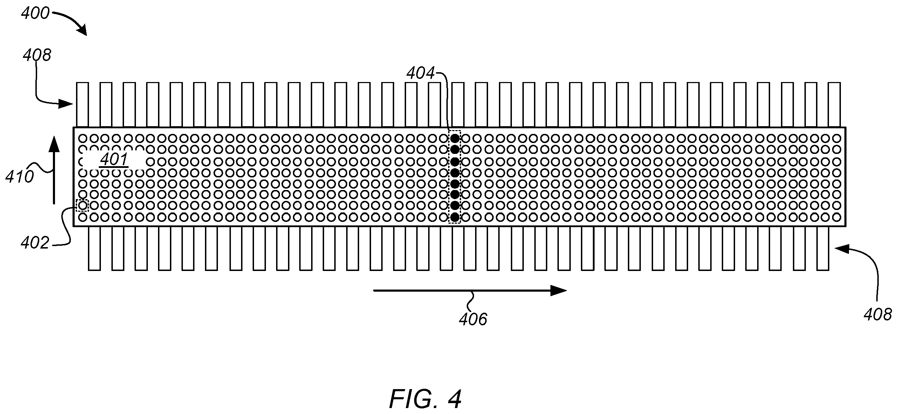

Another type of SLM including a multi-pixel, linear array of MEMS based two-dimensional (2D) diffractors, such as a Linear Planar Light Valve (LPLV^{™}) commercially available from Silicon Light Machines, Inc., of San Jose, California, which is particularly advantageous for use in laser marking will now be described with reference to FIGs. 3A through 3C and FIG. 4.

For purposes of clarity, many of the details of fabricating and operating MEMS based two-dimensional (2D) diffractors, which are widely known and not relevant to the present invention, have been omitted from the following description. MEMS based 2D diffractors are described in greater detail, for example, in commonly assigned U.S. Patent Serial No. 7,064,883, entitled, "Two-Dimensional Spatial Light Modulator," by Alexander Payne et al., issued on June 20, 2006, and incorporated herein by reference in its entirety.

FIG. 3A illustrates a schematic block diagram of a sectional side view of a 2D modulator or diffractor **300** in a quiescent or un-driven state. Referring to FIG. 3A, the 2D diffractor **300** generally includes a piston layer **302** suspended over a surface of a substrate **304** by posts **306** at corners of the piston layer and/or 2D diffractor. The piston layer **302** includes an electrostatically deflectable piston **302a** and a number of flexures **302b** through which the piston is flexibly or movably coupled to the posts **306.** A faceplate **308** overlying the piston layer **302** includes a first light reflective surface **310** and an aperture or cut-out portion **312** which separates the faceplate from a second reflective surface **314** on or attached to the piston **302a.** The second light reflective surface **314** can either be formed directly on the top surface of the piston **302a,** or, as in the embodiment shown, on a mirror **316** supported above and separated from the piston **302a** by a central post **318** extending from the piston to the mirror. The first and second light reflective surfaces **310, 314,** have equal area and reflectivity so that in operation electrostatic deflection of the piston **302a** caused by an electrode **320** formed in or on the piston layer **302** and an electrode **322** in the substrate **304** brings light reflected from the first light reflective surface **310** into constructive or destructive interference with light reflected from the second light reflective surface **314.**

Generally, the electrode **322** in the substrate **304** is coupled to one of a number drive channels in a drive circuit or driver **324,** which can be integrally formed in the substrate adjacent to or underlying the 2D diffractor **300,** as in the embodiment shown. The electrode **322** in the substrate **304** can be coupled to the driver **324** through a via extending through the substrate from the driver to the electrode, and the electrode **320** formed in or on the piston layer **302** can be coupled to the driver or an electrical ground through a conductor extending through one of the posts **306** and the piston layer. As explained in greater detail below, typically multiple individual 2D diffractors **300** are grouped or ganged together under control of a single drive channel to function as a single pixel in the multi-pixel, linear array of the SLM.

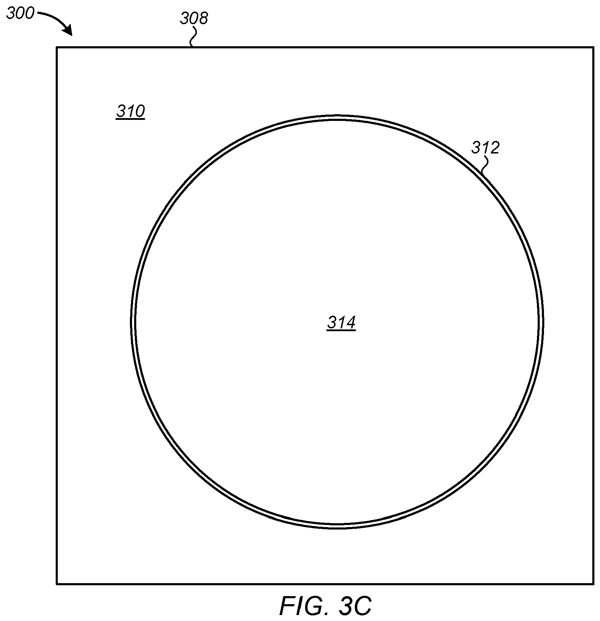

FIG. 3B is a schematic block diagram of the 2D diffractor **300** of FIG. 3A in an active or driven state, showing the piston **302a** deflected towards the substrate **304,** and FIG. 3C is a top view of the 2D diffractor of FIGs. 3A and 3B illustrating the static first light reflective surface **310** and the movable second light reflective surface **314.**

An exemplary multi-pixel, linear array of dense-packed, MEMS based 2D diffractors will now be described with reference to the block diagram of FIG. 4. FIG.4 is a planar top view of a SLM **400** including a linear array **401** of 2D diffractors **402,** such as those shown in FIGs. 3A-C, grouped or coupled together to a number of drive channels to or pixels.

Referring to FIG. 4, in one embodiment the 2D diffractors **402** are grouped into a linear array **401** of interleaved channels or pixels **404** along a first, horizontal or longitudinal axis **406.** Each of the 2D diffractors **402** in a single pixel **404** share a common drive channel or driver **408.** Although in the embodiment shown each pixel **404** is depicted as having a single column of 12 2D diffractors **402** grouped along a transverse or vertical or transverse axis **410** perpendicular to the horizontal or longitudinal axis **406** of the array, this is merely to facilitate illustration of the array. It will be appreciated that each channel or pixel can include any number of 2D diffractors arranged in one or more columns of any length across the width or vertical or transverse axis of the array without departing from the spirit and scope of the invention. For example, in one embodiment of the SLM **400** particularly suited for the spectral shaping systems and methods of the present disclosure, each pixel **404** includes a single column of 40 diffractors grouped along the transverse axis **410** of the array. Similarly, the SLM **400** can include an array **401** of any number of pixels **404** or a number of individual arrays **401** placed end to end adjacent to one another. This later configuration can help to increase power handling of the SLM **400** as the optically active area of the array **401** gets larger by increasing the number of columns of diffractors per pixel. If the damage threshold per diffractor is constant, power handling can be increased proportional to the area increase.

In order to maximize or provide sufficient contrast for the SLM **400** it is desirable that incident light from an illumination source, have a numerical aperture (NA) or cone angle (Θ) which is smaller than the first-order diffraction angle (*θ*) of the diffractive SLM **400.** The diffraction angle (*θ*) of the SLM is defined as the angle between light reflected from a pixel **404** in the 0^{th} order mode or state, and light reflected from the same pixel in the plus and/or minus 1^{st} order mode. However, according to the grating equation, diffraction angles of a periodic surface, such as the array **401** of the SLM **400,** are set by a ratio of wavelength of light incident on the array to a spatial period or pitch of features of the periodic surface, i.e., the pixels **404.** In particular, the grating equation states: $sin θ = m λ / Λ$ where *θ* is a diffraction angle of light reflected from the surface, m is order of diffracted ray (integer), *λ* is the wavelength of the incident light, and *Λ* is a spatial or pitch of the diffractor **402.** When we focus on a single pixel which has multiple 2D diffractors 402 and the incident light is ideal plane wave or has a numeric aperture (NA) = 0, the light spreads due to Huygen-Fresnel principle. The spreading angle *Θ* is defined: $Θ = λ / D$ where *D* is a pixel size.

Achieving adequate contrast with conventional grating based SLMs requires either limiting illumination NA by means of an aperture (and suffering the associated throughput loss) , or providing a large diffraction angle by reducing the size and spatial period or pitch of the individual diffractors. However, this latter approach is problematic for a number of reasons including the need for larger, higher voltage drive circuits to drive smaller, movable grating elements, and a reduction of an optical power handling capability of the SLM resulting from such smaller grating elements.

In contrast to conventional grating based SLMs, a SLM **400** including MEMS-based, 2D diffractors **402**, such as the LPLV^{™} is configured to have multiple pixels **404** each pixel including several 2D diffractors **402** arranged along the transverse or vertical axis **410** of the array (twelve in the embodiment shown), but with a much smaller number, generally only one or two diffractors, arranged along the horizontal or longitudinal axis **406.** Because of this, the spreading angle *Θ_{H}* of diffracted light from the pixel **404** along the longitudinal axis, where the pixel size is much smaller than along the vertical or transverse axis, is much larger than the spreading angle *Θ _{V}* of the pixel along the transverse axis. Conversely, the numerical aperture of illumination in the vertical direction (array short axis) can be much larger than the numerical aperture in the horizontal direction (array long axis) since the latter is limited by the diffraction angle of the SLM in order to achieve sufficient contrast. Thus by using a linear array of 2D diffractors in combination with an asymmetric illumination NA in the longitudinal and transverse directions, the overall throughput of the spectral shaper can be improved.

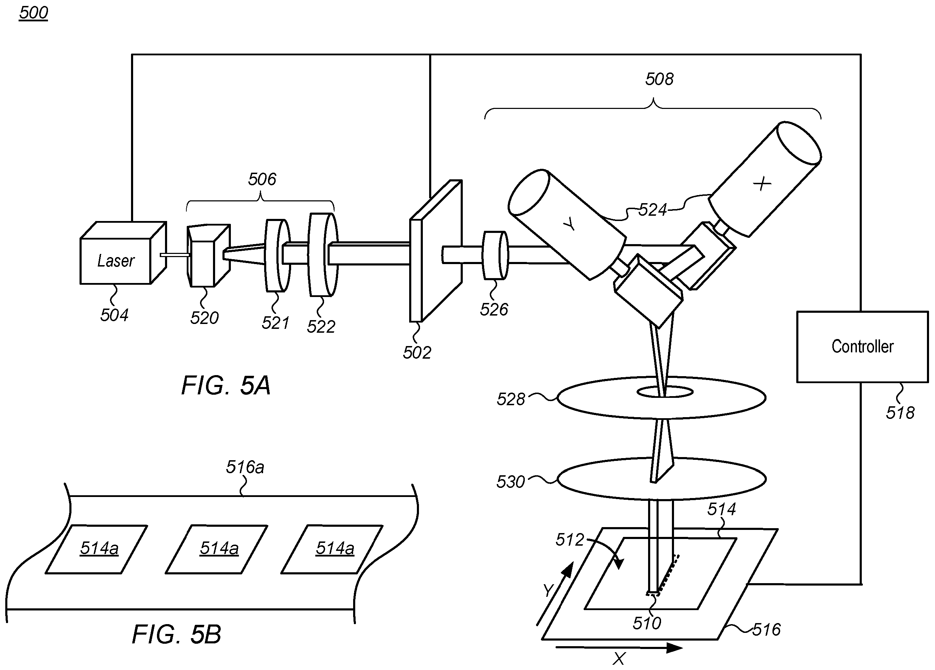

FIG. 5A is a schematic block diagram of an embodiment of a laser marking system **500** including an SLM **502** with a multi-pixel, linear array of MEMS based diffractors, and galvanometric mirrors for scanning. For purposes of clarity and to simplify the drawings the optical light path is shown as being unfolded causing the SLM **502** to appear as transmissive. However, it will be understood that because the SLM **502** is reflective the actual light path is folded to an angle of 90° or less at the SLM.

Referring to FIG. 5A, the laser marking system **500** includes, in addition to the SLM **502,** a laser **504** operable to generate laser light used to illuminate the SLM, illumination optics **506** to direct laser light onto the SLM, imaging optics **508** operable to focus a substantially linear swath of modulated light **510** onto a surface **512** of a workpiece **514** on or affixed to a fixture **516** or stage, and a controller **518** operable to control the SLM, laser and imaging optics to scan the linear swath of modulated light across the surface of the workpiece to record a 2D image thereon.

As noted above, the laser **504** is capable of operating in UV wavelengths of from 355 nm through IR wavelengths up to about 2000 nm in either CW mode, or in a pulse mode with widths or durations of from about 1 fs up to about 500 ns at a repetition rate of from about 10 kHz up to about 300 kHz, and at energy ranges of from about 10 microjoules (µJ) up to greater than 10 millijoules (mJ).

The SLM **502** can include a multi-pixel; linear array of MEMS based, ribbon-type diffractors, such as shown in FIGs. 2A through 2C, or a multi-pixel, linear array of 2D diffractors, such as shown in FIGs. 3A through 3C and FIG. 4.

The illumination optics 506 can include a beam forming optical system to direct laser light onto the SLM **502.** Referring to FIG. 5A, elements of the beam forming optical system can include a Powell lens **520,** a long axis collimating lens **521,** and a cylindrical, short axis focusing lens **522** to shape or focus the illumination into a rectangular beam or line of illumination extending substantially uniformly across the linear array of the SLM **502.**

The imaging optics **508** can include galvanometric mirrors **524** to scan the linear swath of modulated light **510** across the surface **512** of the workpiece **514,** a number of cylindrical lens **526** to direct modulated light to the galvanometric mirrors, and a Fourier aperture **528** to separate a 0^{th} order beam in the modulated light from 1^{st} order beams, and a Fourier Transform (FT) lens **530** to focus the modulated light onto the surface of the workpiece.

Preferably, the cylindrical lens **526** and FT lens **530** of the imaging optics include fused silica lenses to reduce thermal focus shift of the modulated light focused onto the surface **512** of a workpiece **514.** In some embodiments, one or more of the lenses **520, 521, 522** of the illumination optics **506** can also include fused silica lenses to reduce thermal focus shift of the laser light focused onto the SLM **502.**

The fixture **516** on which the workpiece **514** to be marked is placed or affixed can include a static fixture, or a movable stage operable to move or reposition the workpiece relative to a substantially stationary linear swath of modulated light, to scan the linear swath of modulated light across the surface of the workpiece. As noted above, in either embodiment, whether static or movable, the fixture **516** preferably includes a number of sensors and signaling means to signal other components in the laser marking system when the workpiece is in proper position to be marked.

In an alternative embodiment shown in FIG. 5B, the fixture **516** includes a movable belt **516a** operable to move a number of individual parts or workpieces **514a** past a focus of the **500** quickly and efficiently mark or record an image or images on a number of parts or workpieces. It will be understood that because a speed at which data can be loaded to the controller **518** for the SLM **502** is independent of and much greater than a speed at which the fixture **516** or belt **516a** is moved and the image recorded, the laser system **500** can customize the image recorded on each individual part or workpiece **514/514a.** Such images can include, for example, a serial number, part number, and data or a data sheet for the part.

Depending on the size of the linear swath of modulated light **510** and/or an image to be recorded it can be recorded on the surface **512** of a workpiece **514** in a single scan or single-stripe of the linear swath of modulated light **510** across the surface along a single axis, or by multiple scans or stripes (multi-stripes) of the linear swath of modulated light across the surface along a first axis perpendicular to a long axis of the linear swath of modulated light, followed by repositioning the linear swath of modulated light along a second axis parallel to the long axis of the linear swath.

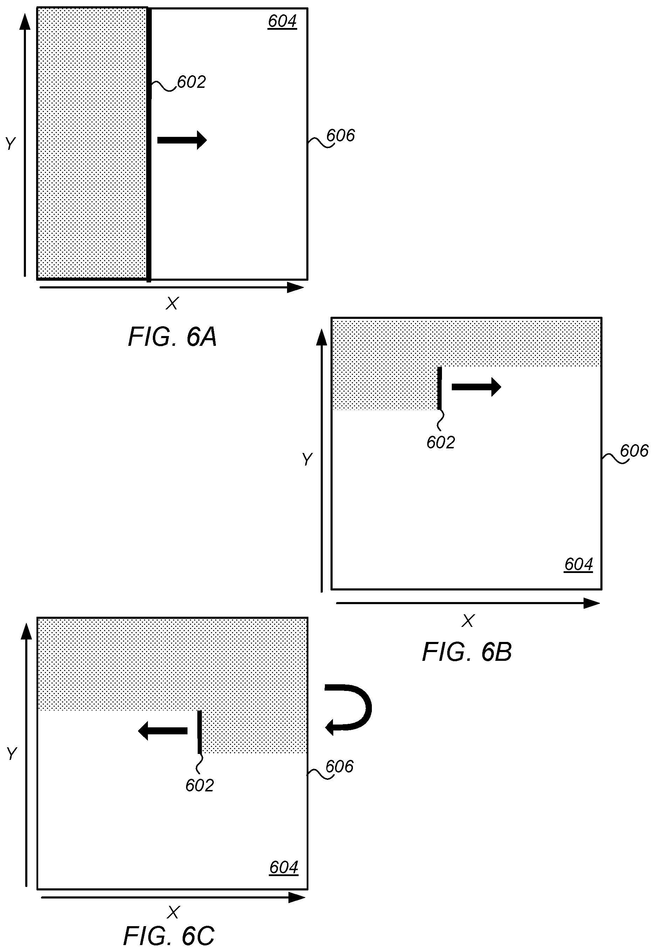

FIGs. 6A-6C are schematic block illustrating single-stripe and multi-stripe scanning using a laser marking system, such as that shown in FIGs. 5A and 5B.

FIG. 6A illustrates an embodiment of single-stripe scanning in which a linear swath of modulated light **602** is moved across a surface **604** of the workpiece 606 once in a single direction to record an image in a single pass or scan. It will be understood that this embodiment provides the shortest write-time, in some embodiments less than 1 second, and can reduce the complexity of the laser marking system by requiring only a single axis scanner in the X-direction. It is noted however that a laser marking systems using single-stripe scanning may require a higher energy laser of 1 millijoule or more, depending on a physical size of the pixels in the linear array of the SLM relative to the linear swath of modulated light **602** may have lower resolution and contrast than a multi-stripe system using a smaller or shorter linear swath of modulated light **602** and stitching together multiple scans or passes to form an image.

FIG. 6B illustrates an embodiment of multi-stripe scanning in which the linear swath of modulated light **602** is moved across the surface **604** of the workpiece **606** multiple times in the X-direction followed by indexing or repositioning the linear swath of modulated light in a Y-direction and repeating the scan in the same X-direction to record an image using multiple scans or passes stitched together. By stitched together it can mean either that the second and subsequent scans overlap the prior scan or that scans abut or adjoin one another on the surface **604** of the workpiece **606** substantially without overlapping. It will be understood that while this multi-stripe method has longer write-times than the single-stripe approach it is still significantly faster than the point-by-point method of prior laser marking systems using DMD or LCOS modulators. It will be further understood that the shorter long axis of the linear swath of modulated light **602** on enables the use of lower power lasers, while providing greater resolution and contrast in the recorded image.

FIG. 6C illustrates another embodiment of multi-stripe scanning in which the linear swath of modulated light **602** is not reset to an initial starting point on the X-axis prior to starting a second or subsequent scan, but rather reverses direction of the scan in the X-direction after indexing or repositioning the linear swath of modulated light in the Y-direction. It will be understood that this embodiment provides a shorter write-time than that of FIG. 6B by eliminating the need reposition an X-axis galvanometric mirror or a movable stage or fixture following completion of each scan in the X-direction, while proving the same improvement in resolution and contrast and enabling use of a lower power laser. As in the embodiment described with respect to FIG. 6B the multiple scans or passes can be stitched together in either overlapping or non-overlapping passes.

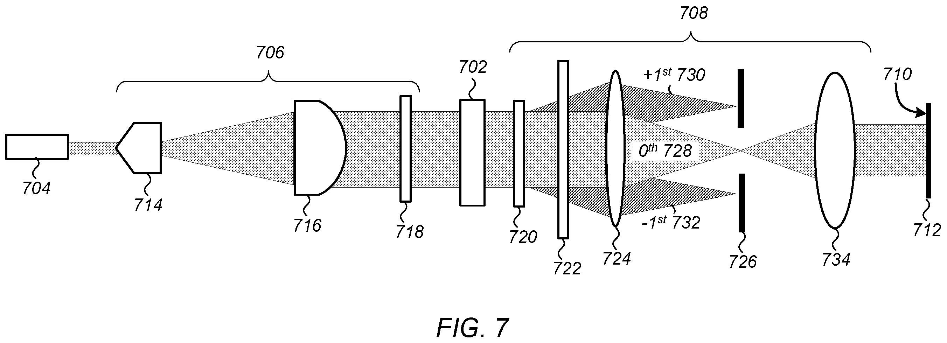

FIG. 7 is an unfolded optics diagram illustrating illumination and imaging light paths along a vertical or longitudinal axis of a linear array for a laser marking system showing the separation of a 0^{th} order beam in the modulated light from 1^{st} order beams. For purposes of clarity and to simplify the drawings the optical light path is shown as being unfolded causing the SLM **702** to appear as transmissive. However, as noted above, it will be understood that because the SLM **702** is reflective the actual light path is folded to an acute angle at the SLM.

Referring to FIG. 7, the light path begins at a laser **704** and passes through anamorphic illumination optics **706,** to illuminate a substantially linear portion of a linear array of the SLM **702,** and imaging optics **708** to focus the modulated light onto a surface **710** of a workpiece **712.** In some embodiments, such as that shown, the illumination optics **706** are anamorphic illumination optics and can include a Powell lens **714,** a long axis collimating lens **716,** and a cylindrical, short axis focusing lens **718** to shape or focus the illumination into a substantially rectangular beam or line of illumination extending substantially uniformly across the linear array of the SLM **702.** The imaging optics **708** can include a number of cylindrical lens **720** to direct modulated light to one or more galvanometric mirrors **722,** a first Fourier Transform (FT) lens **724,** a Fourier aperture **726** to separate a 0^{th} order beam **728** in the modulated light from ±1^{st} order beams **730, 732,** and a second inverse Fourier Transform (FT) lens **734.**

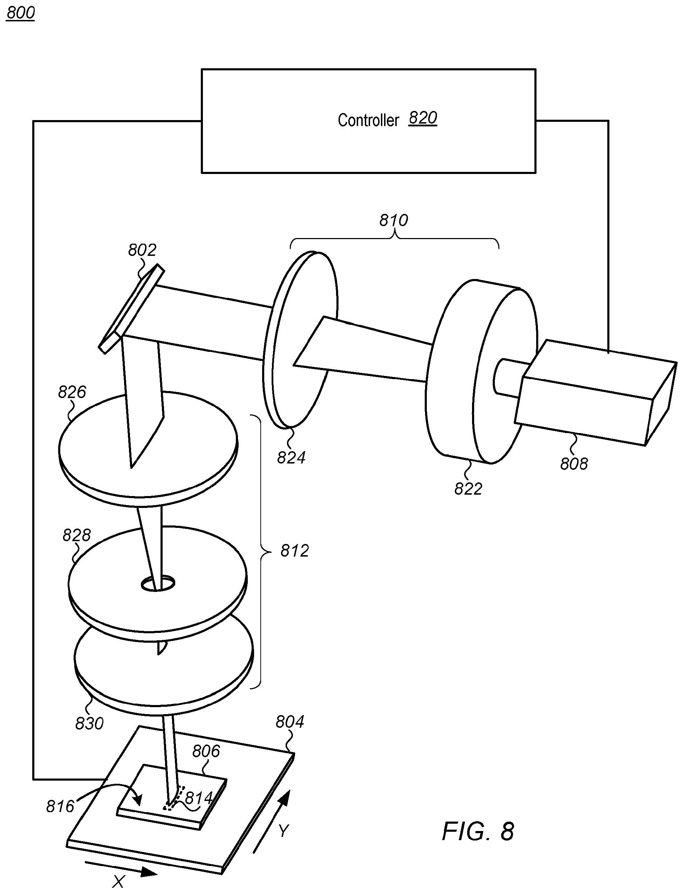

FIG. 8 is a schematic block diagram of another embodiment of a laser marking system **800** including an SLM **802** with a multi-pixel, linear array of MEMS based diffractors, and a moving fixture or stage **804** to which a workpiece **806** can be affixed. Referring to FIG. 8, the laser marking system **800** further includes a laser **808** operable to generate laser light used to illuminate the SLM **802,** illumination optics **810** to direct laser light onto the SLM, imaging optics **812** operable to focus a substantially linear swath of modulated light **814** onto a surface **816** of the workpiece **806** on or affixed to the movable fixture or stage **804,** and a controller **820** operable to control the SLM, laser and movable stage to scan the linear swath of modulated light across the surface of the workpiece to record a 2D image thereon.

As noted above, the laser **808** is capable of operating in UV wavelengths of from 355 nm through IR wavelengths up to about 2000 nm in either CW mode, or in a pulse mode with widths or durations of from about 1 fs up to about 500 ns at a repetition rate of from about 10 kHz up to about 300 kHz, and at energy ranges of from about 10 microjoules (µJ) up to greater than 10 millijoules (mJ).

The SLM **802** can include a multi-pixel; linear array of MEMS based, ribbon-type diffractors, such as shown in FIGs. 2A through 2C, or a multi-pixel, linear array of 2D diffractors, such as shown in FIGs. 3A through 3C and FIG. 4.

The illumination optics **810** can include a beam forming optical system **822** to direct a substantially rectangular beam onto the SLM **802.** Although not shown in this figure, elements of the beam forming optical system **822** can include a Powell lens and a long axis collimating lens, as shown in FIGs. 5 and 7. The illumination optics **810** can further include a cylindrical, short axis focusing lens **824** to direct or focus the rectangular beam substantially uniformly across the linear array of the SLM **802.**

The imaging optics **812** can include a first Fourier Transform (FT) lens **826,** a Fourier aperture **828** to separate a 0^{th} order beam in the modulated light from ±1^{st} order beams, and a second inverse Fourier Transform (FT) lens **830** to focus the modulated light onto the surface 816 of the workpiece **806.** As in the embodiments described above, the FT lenses **826, 830,** of the imaging optics **812** can include fused silica lenses to reduce thermal focus shift of the modulated light focused onto the surface **816** of the workpiece **806.** In some embodiments, one or more of the elements of the beam forming optical system **822** the focusing lens **824** of the illumination optics **810** can also include fused silica lenses to reduce thermal focus shift of the laser light focused onto the SLM **802.**

The fixture or stage **804** on which the workpiece **806** to be marked is placed or affixed can move or at least along a first or X-axis relative to the stationary, substantially linear swath of modulated light **814** to perform a single-stripe scan as described above with reference to FIG. 6A. More preferably, the stages **804** is further operable to reposition the workpiece **806** held thereon relative to the linear swath of modulated light **814** along a second or Y-axis parallel to the long axis of the linear swath to perform one of the multi-stripe scans as described above with reference to FIGs. 6B and 6C.

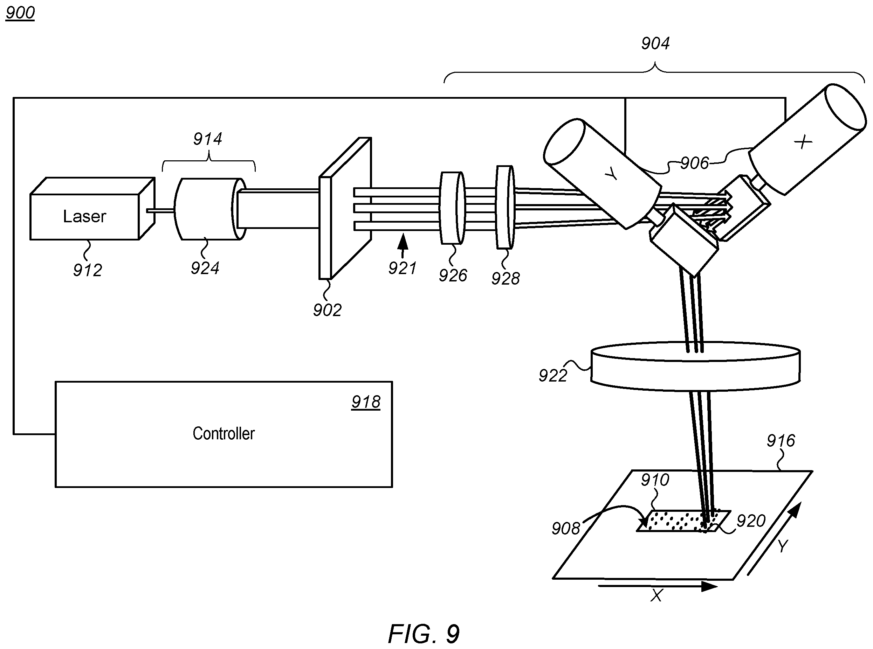

FIG. 9 is a schematic block diagram of another embodiment of a laser marking system **900** including an SLM **902** with a multi-pixel, linear array of MEMS based diffractors, and with imaging optics **904** including optical elements operable to focus a modulated light beam before the galvanometric mirrors **906** used to scan the modulated light beam across a surface **908** of a workpiece **910.** As with the embodiment shown and described above with reference to FIGs. 5A and 5B, for purposes of clarity and to simplify the drawings the optical light path is shown as being unfolded causing the SLM **902** to appear as transmissive. However, it will be understood that because the SLM **902** is reflective the actual light path is folded to an angle of 90° or less at the SLM.

Referring to FIG. 9, the laser marking system **900** further includes a laser **912** operable to generate laser light used to illuminate the SLM **902,** illumination optics **914** to direct laser light onto the SLM, a static fixture **916** on which the workpiece **910** to be marked is placed or affixed, and a controller **918** operable to control the SLM, laser and the galvanometric mirrors **906** to scan a swath of modulated light **920** across the surface **908** of the workpiece to record a 2D image thereon. It is noted that although modulated from the SLM **902** through the imaging optics **904** is shown as separate beams of modulated light or beamlets **921** to represent light and dark modulated light from individual pixels or groups of pixels, as in embodiments of the laser marking systems **500, 800,** described above the imaging optic **904** of the laser marking system **900** are operable to illuminate a substantially linear or rectangular swath of modulated light **920** on the surface **908** of the workpiece **910.** Optionally, as in the embodiment shown, the laser marking system **900** can further include a window **922** in an enclosure (not shown) enclosing the laser marking system to protect the galvanometric mirrors **906.**

As noted above, the laser **912** is capable of operating in UV wavelengths of from 355 nm through IR wavelengths up to about 2000 nm in either CW mode, or in a pulse mode with widths or durations of from about 1 fs up to about 500 ns at a repetition rate of from about 10 kHz up to about 300 kHz, and at energy ranges of from about 10 microjoules (µJ) up to greater than 10 millijoules (mJ).

As also noted above, the SLM **902** can include a multi-pixel; linear array of MEMS based, ribbon-type diffractors, such as shown in FIGs. 2A through 2C, or a multi-pixel, linear array of 2D diffractors, such as shown in FIGs. 3A through 3C and FIG. 4.

The illumination optics **914** can include a beam forming optical system **924** to form and direct a substantially rectangular beam substantially uniformly across the linear array of the SLM **902.** Although not shown in this figure, elements of the beam forming optical system **924** can include a Powell lens and a long axis collimating lens, as shown in FIGs. 5 and 7.

In accordance with the present embodiment the imaging optics **904** include a first focusing cylinder lens **926** located before the galvanometric mirrors **906** to focus light along an X-axis at the surface **908** of the workpiece **910,** where the X-focus determines a width of the swath of modulated light **920,** and a second focusing cylinder lens **928** to focus light along a Y-axis, where the Y-focus determines a height of the swath of modulated light.

Finally, as in the embodiments described above, the lenses **926, 928,** of the imaging optics **904** can include fused silica lenses to reduce thermal focus shift of the modulated light focused onto the surface **908** of the workpiece **910.** In some embodiments, one or more of the elements of the beam forming optical system **924** of the illumination optics **914** can also include fused silica lenses to reduce thermal focus shift of the laser light focused onto the SLM **902.**

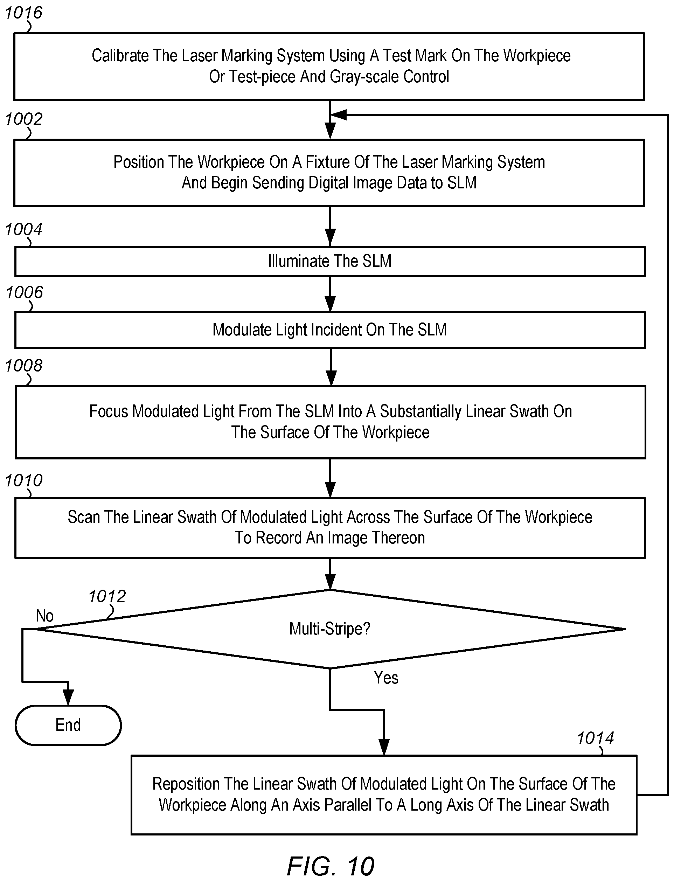

FIG. 10 is a flowchart of a method for modifying or marking a surface using a laser marking system including a MEMS based SLM. Referring to FIG. 10, the method begins with positioning a workpiece on a fixture of a laser marking system, and beginning to send digital image data to a SLM of the laser marking system **(1002).** When it has been detected that the workpiece is positioned on the fixture, digital image data received by the SLM, and the diffractors settled, generating light from a laser **(1004).** Generally, this can be accomplished by sending a pulse of the appropriate duration to the laser through a control bus. Next, light from the laser is optically coupled to the SLM to substantially uniformly illuminate a linear array of the SLM, and light incident on the SLM modulated **(1006).** Modulated light from the SLM is then projected and focused into a substantially linear swath on a surface of the workpiece using imaging optics; the linear swath includes light from multiple pixels of the SLM **(1008).** Next, the laser, SLM, and a scanner or galvanometric mirrors in the imaging optics operated to scan the linear swath of modulated light across the surface of the workpiece to record an image thereon **(1010).** It is then determined if a multi-stripe is necessary or desired **(1012).** If a multi-stripe is not necessary, i.e., if a single-stripe scan is sufficient to record the desired image, the process ends. If a multi-stripe is necessary, due either to a size of the image, a length of the linear swath of modulated light, or a desired resolution or contrast in the image recorded, the linear swath of modulated light is repositioned or indexed on the surface of the workpiece along an axis parallel to a long axis of the linear swath **(1014)** and the process repeated.

Optionally, as in the embodiment shown in FIG. 10, the method can further include an initial calibration step (step **1016),** in which the laser marking system is calibrated using test mark or pattern either on the workpiece or a test-piece positioned on the fixture, adjusting a for each pixel a precise dosage of light projected onto the workpiece using gray-scale control of modulated light intensity to calibrate for non-uniformities in the light. Evaluation of the test mark can be accomplished either manually by a user of the laser marking system or automatically using a scanner or camera integrated into the system.

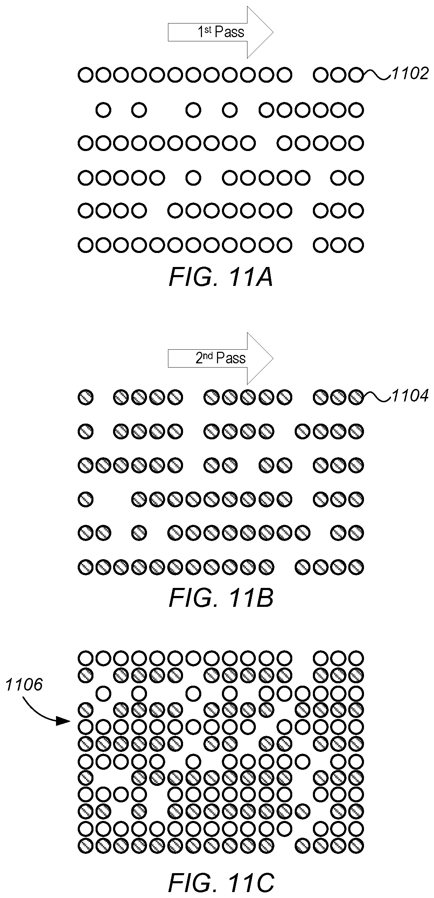

FIGs. 11A through 11C are schematic block diagrams illustrating a method of modifying or marking a surface using interleaving of two or more scans of the surface. 20. Referring to FIG. 11A the method begins with controlling the laser, SLM, and imaging optics of the laser marking system to scan a linear swath of modulated light across the surface of the workpiece in a 1^{st} pass to mark a first number of spots **1102** in first locations, and, referring to FIG. 11B, at a second time in a 2^{nd} pass to mark a second number of spots **1104** in second locations, interleaved with the first locations to record a desired image **1106,** as shown in FIG. 11C. In these figures, the SLM modulates along a vertical or Y-direction, while the workpiece is scanned in a horizontal or X-direction. It will be understood this is method reduces a thermal load on the SLM and imaging optics.

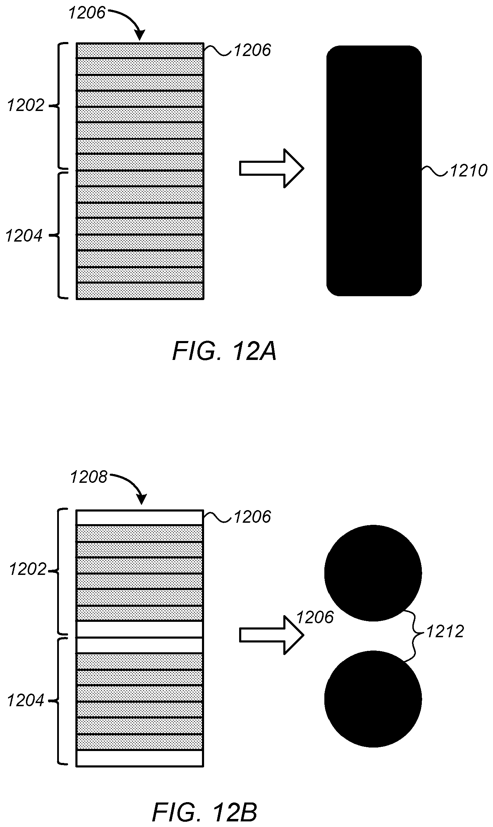

In another embodiment, the method can further include pixel shaping to improve resolution in images having high density patterns. FIGs. 12A and 12B are schematic block diagrams two adjacent groups **1202, 1204** of eight pixels **1206** in a linear array **1208** of MEMS based 2D diffractors, such as an LPLV^{™}, illustrating a pixel shaping method for recording an image with a high density pattern. Referring to FIG. 12A it is seen that when all eight pixels **1206** in adjacent groups **1202, 1204,** are on in an attempt to record adjacent dots on a surface of a workpiece, crosstalk between the groups of pixels result in a printed line **1210** rather than the desired adjacent dots. By turning off adjacent pixels **1206** between the adjacent groups **1202, 1204,** resolution is improved resulting in the desired adjacent dots **1212,** as shown in FIG. 12B.

Thus, embodiments of a laser marking system including a spatial light modulator (SLM) with a multi-pixel, linear array of MEMS based diffractors, and systems using the same have been described. Embodiments of the present invention have been described above with the aid of functional and schematic block diagrams illustrating the implementation of specified functions and relationships thereof. The boundaries of these functional building blocks have been arbitrarily defined herein for the convenience of the description. Alternate boundaries can be defined so long as the specified functions and relationships thereof are appropriately performed.

## Claims

1. A laser marking system comprising:
a fixture on which a workpiece having a surface to be marked is positioned;
a spatial light modulator (SLM) comprising a multi-pixel, linear array of MEMS based diffractors;
a laser operable to illuminate the SLM;
imaging optics operable to focus a substantially linear swath of modulated light onto
the surface of the workpiece, the linear swath comprising light from multiple pixels of the SLM; and
a controller operable to control the fixture, SLM, laser and imaging optics to mark the surface of the workpiece to record an image thereon,
wherein the SLM is operable to send a signal to the laser when image data loaded to the SLM from the controller is ready to be recorded on to the workpiece so that the laser can be pulsed.

2. The laser marking system of claim 1 wherein each of the MEMS based diffractors comprises a number of electrostatically deflectable ribbons suspended over a substrate, each ribbon having a light reflective surface, wherein electrostatic deflection of the number of electrostatically deflectable ribbons brings light reflected from the light reflective surface of a first electrostatically deflectable ribbon into interference with light reflected from the light reflective surface of a second electrostatically deflectable ribbon.

3. The laser marking system of claim 1 wherein each of the MEMS based diffractors comprises:
a piston layer suspended over a surface of a substrate by posts at corners thereof, the piston layer including an electrostatically deflectable piston and a number of flexures through which the piston is coupled to the posts;
a first reflective surface over a top surface of the piston; and
a faceplate suspended over the piston layer, the faceplate including a second reflective surface on a top surface of the faceplate, and an aperture through which the piston exposed,
wherein electrostatic deflection of the piston brings light reflected from the first reflective surface into interference with light reflected from the second reflective surface.

4. The laser marking system of claim 3 wherein the controller is operable to provide gray-scale control of the MEMS based diffractors to provide a precise dosage of light from each pixel onto the surface of the workpiece to compensate for non-uniformities in light illuminating the SLM or in modulated transmitted therefrom through the imaging optics.

5. The laser marking system of claim 1 wherein the imaging optics comprise a number of galvanometric mirrors, and wherein the controller is operable to control the number of galvanometric mirrors to scan the linear swath of modulated light across the surface of the workpiece to record a two-dimensional (2D) image thereon.

6. The laser marking system of claim 5 wherein the imaging optics comprise a number of cylindrical lenses to focus modulated light from the SLM onto the number of galvanometric mirrors, and a focus lens to focus the linear swath of modulated light from the number of galvanometric mirrors onto the surface of the workpiece.

7. The laser marking system of claim 1 further including a fixture to which the workpiece is positioned, wherein the fixture includes a number of sensors to signal one or more of the controller, the SLM and the laser when the workpiece is in proper position to record an image thereon, and wherein the controller is operable to control the fixture to provide relative motion the fixture and linear swath of modulated light to scan the linear swath of modulated light across the surface of the workpiece to record a two-dimensional (2D) image thereon.

8. The laser marking system of claim 7 wherein fixture comprises a movable stage on which a multiple workpieces are positioned, and the controller is operable to move the multiple workpieces on the movable stage past a focus of the imaging optics to sequentially record images thereon, and wherein the images recorded on each of the multiple workpieces can be different.

9. The laser marking system of claim 6 wherein the controller is operable to after scanning the linear swath of modulated light a predetermined distance across the surface of the workpiece in a first direction, to reposition the linear swath in a second direction perpendicular to the first direction, and repeat the scanning of the linear swath of modulated light across the surface of the workpiece by the predetermined distance in a third direction parallel and opposite to the first direction.

10. A laser marking system comprising:
a fixture on which a workpiece having a surface to be marked is positioned;
a laser;
a spatial light modulator (SLM) comprising a multi-pixel, linear array of MEMS based diffractors;
illumination optics operable to illuminate the SLM with light from the laser, the illumination optics including a beam forming optical system to direct a rectangular beam onto the SLM;
imaging optics operable to focus a substantially linear swath of modulated light onto the surface of the workpiece, the imaging optics comprising:
a first cylindrical lens to focus modulated light from the SLM in an X focal plane at the surface of the workpiece;
a second cylindrical lens to focus modulated light from the SLM in an Y focal plane, wherein an Y-focus determines a swath height of the linear swath of modulated light on the surface of the workpiece; and
a number of galvanometric mirrors disposed in a light path between the first and second cylindrical lenses and the surface of the workpiece; and
a controller operable to control the laser, SLM, and the number of galvanometric mirrors to scan the linear swath of modulated light across the surface of the workpiece to record a two-dimensional (2D) image thereon,
wherein the SLM is operable to send a signal to the laser when image data loaded to the SLM from the controller is ready to be recorded on to the workpiece so that the laser can be pulsed, and
wherein the fixture includes a number of sensors to signal one or more of the controller, the SLM and the laser when the workpiece is in proper position to record an image thereon.

11. The laser marking system of claim 10 wherein each of the MEMS based diffractors comprises a number of electrostatically deflectable ribbons suspended over a substrate, each ribbon having a light reflective surface, wherein electrostatic deflection of the number of electrostatically deflectable ribbons brings light reflected from the light reflective surface of a first electrostatically deflectable ribbon into interference with light reflected from the light reflective surface of a second electrostatically deflectable ribbon.

12. The laser marking system of claim 10 wherein each of the MEMS based diffractors comprises:
a piston layer suspended over a surface of a substrate by posts at corners thereof, the piston layer including an electrostatically deflectable piston and a number of flexures through which the piston is coupled to the posts;
a first reflective surface over a top surface of the piston; and
a faceplate suspended over the piston layer, the faceplate including a second reflective surface on a top surface of the faceplate, and an aperture through which the piston exposed,
wherein electrostatic deflection of the piston brings light reflected from the first reflective surface into interference with light reflected from the second reflective surface.

13. The laser marking system of claim 10 wherein the imaging optics further comprises a window disposed in a light path between the number of galvanometric mirrors and the surface of the workpiece.

14. The laser marking system of claim 10 further comprising a movable stage on which a multiple workpieces are positioned, and the controller is operable to move the multiple workpieces on the movable stage past a focus of the imaging optics to sequentially record 2D images thereon, and wherein the images recorded on each of the multiple workpieces can be different.

15. The laser marking system of claim 10 wherein the controller is operable to after scanning the linear swath of modulated light a predetermined distance across the surface of the workpiece in a first direction, to reposition the linear swath in a second direction perpendicular to the first direction, and repeat the scanning of the linear swath of modulated light across the surface of the workpiece by the predetermined distance in a third direction parallel and opposite to the first direction.

## Patentansprüche

1. Lasermarkierungssystem, umfassend:
eine Haltevorrichtung, auf der ein Werkstück mit einer zu markierenden Oberfläche positioniert ist;
einen räumlichen Lichtmodulator (SLM), umfassend eine lineare Mehrpixelanordnung von MEMS-basierten Diffraktoren;
einen Laser, der dazu betreibbar ist, den SLM zu beleuchten;
eine Abbildungsoptik, die dazu betreibbar ist, einen im Wesentlichen linearen Streifen modulierten Lichts auf die Oberfläche des Werkstücks zu fokussieren, wobei der lineare Streifen Licht von mehreren Pixeln des SLM umfasst; und
eine Steuerung, die dazu betreibbar ist, die Haltevorrichtung, den SLM, den Laser und die Abbildungsoptik zu steuern, um die Oberfläche des Werkstücks zu markieren und darauf ein Bild aufzuzeichnen,
wobei der SLM dazu betreibbar ist, ein Signal an den Laser zu senden, wenn die von der Steuerung in den SLM geladenen Bilddaten bereit sind, auf dem Werkstück aufgezeichnet zu werden, sodass der Laser gepulst werden kann.

2. Lasermarkierungssystem nach Anspruch 1, wobei jeder der MEMS-basierten Diffraktoren eine Anzahl von elektrostatisch auslenkbaren Bändern umfasst, die über einem Substrat aufgehängt sind, wobei jedes Band eine lichtreflektierende Oberfläche aufweist, wobei eine elektrostatische Auslenkung der Anzahl elektrostatisch auslenkbarer Bänder Licht, das von der lichtreflektierenden Oberfläche eines ersten elektrostatisch auslenkbaren Bandes reflektiert wird, mit Licht, das von der lichtreflektierenden Oberfläche eines zweiten elektrostatisch auslenkbaren Bandes reflektiert wird, zur Interferenz bringt.

3. Lasermarkierungssystem nach Anspruch 1, wobei jeder der MEMS-basierten Diffraktoren umfasst:
eine Kolbenschicht, die durch Stützen an ihren Ecken über einer Oberfläche eines Substrats aufgehängt ist, wobei die Kolbenschicht einen elektrostatisch auslenkbaren Kolben und eine Anzahl von Biegeelementen aufweist, über die der Kolben mit den Stützen gekoppelt ist;
eine erste reflektierende Oberfläche über einer Oberseite des Kolbens; und
eine über der Kolbenschicht aufgehängte Deckplatte, wobei die Deckplatte eine zweite reflektierende Oberfläche auf einer Oberseite der Deckplatte und eine Öffnung, durch die der Kolben freiliegt, aufweist,
wobei eine elektrostatische Auslenkung des Kolbens Licht, das von der ersten reflektierenden Oberfläche reflektiert wird, mit Licht, das von der zweiten reflektierenden Oberfläche reflektiert wird, zur Interferenz bringt.

4. Lasermarkierungssystem nach Anspruch 3, wobei die Steuerung dazu betreibbar ist, eine Graustufensteuerung der MEMS-basierten Diffraktoren bereitzustellen, um eine präzise Dosierung von Licht von jedem Pixel auf die Oberfläche des Werkstücks bereitzustellen, um Ungleichmäßigkeiten in dem den SLM beleuchtenden Licht oder in dem von diesem durch die Abbildungsoptik übertragenen modulierten Licht zu kompensieren.

5. Lasermarkierungssystem nach Anspruch 1, wobei die Abbildungsoptik eine Anzahl von Galvanometerspiegeln umfasst und wobei die Steuerung dazu betreibbar ist, die Anzahl von Galvanometerspiegeln zu steuern, um den linearen Streifen modulierten Lichts über die Oberfläche des Werkstücks zu führen, um darauf ein zweidimensionales (2D) Bild aufzuzeichnen.

6. Lasermarkierungssystem nach Anspruch 5, wobei die Abbildungsoptik eine Anzahl von Zylinderlinsen umfasst, um moduliertes Licht von dem SLM auf die Anzahl von Galvanometerspiegeln zu fokussieren, und eine Fokussierlinse, um den linearen Streifen modulierten Lichts von der Anzahl von Galvanometerspiegeln auf die Oberfläche des Werkstücks zu fokussieren.

7. Lasermarkierungssystem nach Anspruch 1, ferner aufweisend eine Haltevorrichtung, an der das Werkstück positioniert ist, wobei die Haltevorrichtung eine Anzahl von Sensoren aufweist, um einem oder mehreren von der Steuerung, dem SLM und dem Laser zu signalisieren, wenn sich das Werkstück in der richtigen Position befindet, um darauf ein Bild aufzuzeichnen, und wobei die Steuerung dazu betreibbar ist, die Haltevorrichtung zu steuern, um eine Relativbewegung der Haltevorrichtung und des linearen Streifens modulierten Lichts bereitzustellen, um den linearen Streifen modulierten Lichts über die Oberfläche des Werkstücks zu führen, um darauf ein zweidimensionales (2D) Bild aufzuzeichnen.

8. Lasermarkierungssystem nach Anspruch 7, wobei die Haltevorrichtung einen verfahrbaren Tisch umfasst, auf dem mehrere Werkstücke positioniert sind, und die Steuerung dazu betreibbar ist, die mehreren Werkstücke auf dem verfahrbaren Tisch an einem Fokus der Abbildungsoptik vorbeizubewegen, um nacheinander Bilder auf den Werkstücken aufzuzeichnen, und wobei die auf jedem der mehreren Werkstücke aufgezeichneten Bilder unterschiedlich sein können.

9. Lasermarkierungssystem nach Anspruch 6, wobei die Steuerung dazu betreibbar ist, nach dem Führen des linearen Streifens modulierten Lichts über eine vorbestimmte Strecke über die Oberfläche des Werkstücks in einer ersten Richtung den linearen Streifen in einer zweiten Richtung senkrecht zu der ersten Richtung neu zu positionieren und das Führen des linearen Streifens modulierten Lichts über die Oberfläche des Werkstücks um die vorbestimmte Strecke in einer dritten Richtung zu wiederholen, die parallel und entgegengesetzt zu der ersten Richtung ist.

10. Lasermarkierungssystem, umfassend:
eine Haltevorrichtung, auf der ein Werkstück mit einer zu markierenden Oberfläche positioniert ist;
einen Laser;
einen räumlichen Lichtmodulator (SLM), umfassend eine lineare Mehrpixelanordnung von MEMS-basierten Diffraktoren;
eine Beleuchtungsoptik, die dazu betreibbar ist, den SLM mit Licht von dem Laser zu beleuchten, wobei die Beleuchtungsoptik ein strahlformendes optisches System aufweist, um einen rechteckigen Strahl auf den SLM zu richten;
eine Abbildungsoptik, die dazu betreibbar ist, einen im Wesentlichen linearen Streifen modulierten Lichts auf die Oberfläche des Werkstücks zu fokussieren, wobei die Abbildungsoptik umfasst:
eine erste Zylinderlinse, um moduliertes Licht von dem SLM in einer X-Fokalebene an der Oberfläche des Werkstücks zu fokussieren;
eine zweite Zylinderlinse, um moduliertes Licht von dem SLM in einer Y-Fokalebene zu fokussieren, wobei ein Y-Fokus eine Streifenhöhe des linearen Streifens modulierten Lichts auf der Oberfläche des Werkstücks bestimmt; und
eine Anzahl von Galvanometerspiegeln, die in einem Lichtweg zwischen der ersten und der zweiten Zylinderlinse und der Oberfläche des Werkstücks angeordnet sind; und
eine Steuerung, die dazu betreibbar ist, den Laser, den SLM und die Anzahl von Galvanometerspiegeln zu steuern, um den linearen Streifen modulierten Lichts über die Oberfläche des Werkstücks zu führen, um ein zweidimensionales (2D) Bild auf der Oberfläche des Werkstücks aufzuzeichnen,
wobei der SLM dazu betreibbar ist, ein Signal an den Laser zu senden, wenn die von der Steuerung in den SLM geladenen Bilddaten bereit sind, auf dem Werkstück aufgezeichnet zu werden, sodass der Laser gepulst werden kann, und
wobei die Haltevorrichtung eine Anzahl von Sensoren aufweist, um einem oder mehreren von der Steuerung, dem SLM und dem Laser zu signalisieren, wenn sich das Werkstück in der richtigen Position befindet, um ein Bild auf dem Werkstück aufzuzeichnen.

11. Lasermarkierungssystem nach Anspruch 10, wobei jeder der MEMS-basierten Diffraktoren eine Anzahl von elektrostatisch auslenkbaren Bändern umfasst, die über einem Substrat aufgehängt sind, wobei jedes Band eine lichtreflektierende Oberfläche aufweist, wobei eine elektrostatische Auslenkung der Anzahl elektrostatisch auslenkbarer Bänder Licht, das von der lichtreflektierenden Oberfläche eines ersten elektrostatisch auslenkbaren Bandes reflektiert wird, mit Licht, das von der lichtreflektierenden Oberfläche eines zweiten elektrostatisch auslenkbaren Bandes reflektiert wird, zur Interferenz bringt.

12. Lasermarkierungssystem nach Anspruch 10, wobei jeder der MEMS-basierten Diffraktoren umfasst:
eine Kolbenschicht, die durch Stützen an ihren Ecken über einer Oberfläche eines Substrats aufgehängt ist, wobei die Kolbenschicht einen elektrostatisch auslenkbaren Kolben und eine Anzahl von Biegeelementen aufweist, über die der Kolben mit den Stützen gekoppelt ist;
eine erste reflektierende Oberfläche über einer Oberseite des Kolbens; und
eine über der Kolbenschicht aufgehängte Deckplatte, wobei die Deckplatte eine zweite reflektierende Oberfläche auf einer Oberseite der Deckplatte und eine Öffnung, durch die der Kolben freiliegt, aufweist,
wobei eine elektrostatische Auslenkung des Kolbens Licht, das von der ersten reflektierenden Oberfläche reflektiert wird, mit Licht, das von der zweiten reflektierenden Oberfläche reflektiert wird, zur Interferenz bringt.

13. Lasermarkierungssystem nach Anspruch 10, wobei die Abbildungsoptik ferner ein Fenster umfasst, das in einem Lichtweg zwischen der Anzahl von Galvanometerspiegeln und der Oberfläche des Werkstücks angeordnet ist.

14. Lasermarkierungssystem nach Anspruch 10, ferner umfassend einen verfahrbaren Tisch, auf dem mehrere Werkstücke positioniert sind, wobei die Steuerung dazu betreibbar ist, die mehreren Werkstücke auf dem verfahrbaren Tisch an einem Fokus der Abbildungsoptik vorbeizubewegen, um nacheinander 2D-Bilder auf den Werkstücken aufzuzeichnen, und wobei die auf jedem der mehreren Werkstücke aufgezeichneten Bilder unterschiedlich sein können.

15. Lasermarkierungssystem nach Anspruch 10, wobei die Steuerung dazu betreibbar ist, nach dem Führen des linearen Streifens modulierten Lichts über eine vorbestimmte Strecke über die Oberfläche des Werkstücks in einer ersten Richtung den linearen Streifen in einer zweiten Richtung senkrecht zu der ersten Richtung neu zu positionieren und das Führen des linearen Streifens modulierten Lichts über die Oberfläche des Werkstücks um die vorbestimmte Strecke in einer dritten Richtung zu wiederholen, die parallel und entgegengesetzt zu der ersten Richtung ist.

## Revendications

1. Système de marquage laser comprenant :
un dispositif de maintien sur lequel est positionnée une pièce à usiner présentant une surface à marquer ;
un modulateur spatial de lumière (SLM) comprenant une matrice linéaire multipixels de diffracteurs à base de MEMS ;
un laser conçu pour éclairer le SLM ;
une optique d'imagerie conçue pour focaliser une bande de lumière modulée sensiblement linéaire sur la surface de la pièce à usiner, la bande linéaire comprenant de la lumière provenant de multiples pixels du SLM ; et
un contrôleur conçu pour commander le dispositif de maintien, le SLM, le laser et l'optique d'imagerie afin de marquer la surface de la pièce à usiner pour y enregistrer une image,
dans lequel le SLM est conçu pour envoyer un signal au laser lorsque des données d'image chargées dans le SLM depuis le contrôleur sont prêtes à être enregistrées sur la pièce à usiner, de sorte que le laser puisse être activé par impulsions.

2. Système de marquage laser selon la revendication 1, dans lequel chacun des diffracteurs à base de MEMS comprend une pluralité de rubans déviables électrostatiquement suspendus au-dessus d'un substrat, chaque ruban présentant une surface réfléchissant la lumière, dans lequel la déviation électrostatique de la pluralité de rubans déviables électrostatiquement amène la lumière réfléchie par la surface réfléchissant la lumière d'un premier ruban déviable électrostatiquement à interférer avec la lumière réfléchie par la surface réfléchissant la lumière d'un deuxième ruban déviable électrostatiquement.

3. Système de marquage laser selon la revendication 1, dans lequel chacun des diffracteurs à base de MEMS comprend :
une couche de piston suspendue au-dessus d'une surface d'un substrat par des montants situés aux coins de celle-ci, la couche de piston incluant un piston déviable électrostatiquement et une pluralité d'éléments flexibles par l'intermédiaire desquels le piston est couplé aux montants ;
une première surface réfléchissante située sur une surface supérieure du piston ; et
une plaque frontale suspendue au-dessus de la couche de piston, la plaque frontale incluant une deuxième surface réfléchissante sur une surface supérieure de la plaque frontale, ainsi qu'une ouverture à travers laquelle le piston est exposé,
dans lequel la déviation électrostatique du piston amène la lumière réfléchie par la première surface réfléchissante à interférer avec la lumière réfléchie par la deuxième surface réfléchissante.

4. Système de marquage laser selon la revendication 3, dans lequel le contrôleur est conçu pour assurer un contrôle des niveaux de gris des diffracteurs à base de MEMS afin de fournir une dose précise de lumière provenant de chaque pixel sur la surface de la pièce à usiner, afin de compenser les non-uniformités de la lumière éclairant le SLM ou de la lumière modulée transmise par celui-ci à travers l'optique d'imagerie.

5. Système de marquage laser selon la revendication 1, dans lequel l'optique d'imagerie comprend une pluralité de miroirs galvanométriques et dans lequel le contrôleur est conçu pour commander la pluralité de miroirs galvanométriques afin de balayer la bande linéaire de lumière modulée au travers de la surface de la pièce à usiner, afin d'y enregistrer une image bidimensionnelle (2D).

6. Système de marquage laser selon la revendication 5, dans lequel l'optique d'imagerie comprend une pluralité de lentilles cylindriques pour focaliser la lumière modulée provenant du SLM sur les miroirs galvanométriques ainsi qu'une lentille de focalisation pour focaliser la bande linéaire de lumière modulée provenant de la pluralité de miroirs galvanométriques sur la surface de la pièce à usiner.

7. Système de marquage laser selon la revendication 1, comprenant en outre un dispositif de maintien sur lequel la pièce à usiner est positionnée, dans lequel le dispositif de maintien inclut une pluralité de capteurs pour signaler au contrôleur, au SLM et/ou au laser que la pièce à usiner se trouve dans la position adéquate pour y enregistrer une image et dans lequel le contrôleur est conçu pour commander le dispositif de maintien afin d'assurer un mouvement relatif entre le dispositif de maintien et la bande linéaire de lumière modulée, afin de balayer la bande linéaire de lumière modulée au travers de la surface de la pièce à usiner pour y enregistrer une image bidimensionnelle (2D).

8. Système de marquage laser selon la revendication 7, dans lequel le dispositif de maintien comprend une platine mobile sur laquelle sont positionnées une pluralité de pièces à usiner et le contrôleur est conçu pour déplacer la pluralité de pièces à usiner sur la platine mobile au-delà d'un foyer de l'optique d'imagerie afin d'y enregistrer séquentiellement des images et dans lequel les images enregistrées sur chacune des pièces peuvent être différentes.

9. Système de marquage laser selon la revendication 6, dans lequel le contrôleur est conçu pour, après avoir balayé la bande linéaire de lumière modulée sur une distance prédéterminée au travers de la surface de la pièce dans une première direction, repositionner la bande linéaire dans une deuxième direction perpendiculaire à la première direction et répéter le balayage de la bande linéaire de lumière modulée sur la surface de la pièce à usiner sur la distance prédéterminée dans une troisième direction parallèle et opposée à la première direction.

10. Système de marquage laser comprenant :
un dispositif de maintien sur lequel est positionnée une pièce à usiner présentant une surface à marquer ;
un laser ;
un modulateur spatial de lumière (SLM) comprenant une matrice linéaire multipixels de diffracteurs à base de MEMS ;
une optique d'éclairage conçue pour éclairer le SLM avec de la lumière provenant du laser, l'optique d'éclairage incluant un système optique de mise en forme de faisceau pour diriger un faisceau rectangulaire sur le SLM ;
une optique d'imagerie conçue pour focaliser une bande sensiblement linéaire de lumière modulée sur la surface de la pièce, l'optique d'imagerie comprenant :
une première lentille cylindrique pour focaliser la lumière modulée provenant du SLM dans un plan focal X au niveau de la surface de la pièce ;
une deuxième lentille cylindrique pour focaliser la lumière modulée provenant du SLM dans un plan focal Y, dans lequel une focalisation en Y détermine une hauteur de bande de la bande linéaire de lumière modulée sur la surface de la pièce à usiner ; et
une pluralité de miroirs galvanométriques disposés sur un trajet lumineux entre les première et deuxième lentilles cylindriques et la surface de la pièce à usiner ; et
un contrôleur apte à commander le laser, le SLM et les miroirs galvanométriques pour balayer la bande linéaire de lumière modulée au travers de la surface de la pièce à usiner afin d'y enregistrer une image bidimensionnelle (2D),
dans lequel le SLM est apte à envoyer un signal au laser lorsque des données d'image chargées dans le SLM depuis le contrôleur sont prêtes à être enregistrées sur la pièce à usiner, de sorte que le laser puisse être activé par impulsions et
dans lequel le dispositif de maintien comprend une pluralité de capteurs pour signaler à un ou plusieurs du contrôleur, du SLM et/ou du laser que la pièce à usiner se trouve dans la position appropriée pour y enregistrer une image.

11. Système de marquage laser selon la revendication 10, dans lequel chacun des diffracteurs à base de MEMS comprend une pluralité de rubans déviables électrostatiquement suspendus au-dessus d'un substrat, chaque ruban présentant une surface réfléchissant la lumière, dans lequel la déviation électrostatique des rubans déviables électrostatiquement amène la lumière réfléchie par la surface réfléchissante d'un premier ruban déviable électrostatiquement à interférer avec la lumière réfléchie par la surface réfléchissante d'un deuxième ruban déviable électrostatiquement.

12. Système de marquage laser selon la revendication 10, dans lequel chacun des diffracteurs à base de MEMS comprend :
une couche de piston suspendue au-dessus d'une surface d'un substrat par des montants situés aux coins de celle-ci, la couche de piston incluant un piston déviable électrostatiquement et une pluralité d'éléments flexibles par lesquels le piston est couplé aux montants ;
une première surface réfléchissante située sur une surface supérieure du piston ; et
une plaque frontale suspendue au-dessus de la couche de piston, la plaque frontale comprenant une deuxième surface réfléchissante sur une face supérieure de la plaque frontale et une ouverture à travers laquelle le piston est exposé,
dans lequel une déflexion électrostatique du piston amène la lumière réfléchie par la première surface réfléchissante à interférer avec la lumière réfléchie par la deuxième surface réfléchissante.

13. Système de marquage laser selon la revendication 10, dans lequel l'optique d'imagerie comprend en outre une fenêtre disposée sur un trajet lumineux entre la pluralité de miroirs galvanométriques et la surface de la pièce à usiner.

14. Système de marquage laser selon la revendication 10, comprenant en outre une platine mobile sur laquelle sont positionnées une pluralité de pièces à usiner et le contrôleur est conçu pour déplacer la pluralité de pièces à usiner sur la platine mobile au-delà d'un foyer de l'optique d'imagerie afin d'y enregistrer séquentiellement des images en 2D et dans lequel les images enregistrées sur chacune des multiples pièces à usiner peuvent être différentes.

15. Système de marquage laser selon la revendication 10, dans lequel le contrôleur est conçu pour, après avoir balayé la bande linéaire de lumière modulée sur une distance prédéterminée au travers de la surface de la pièce à usiner dans une première direction, repositionner la bande linéaire dans une deuxième direction perpendiculaire à la première direction et répéter le balayage de la bande linéaire de lumière modulée au travers de la surface de la pièce à usiner sur la distance prédéterminée dans une troisième direction parallèle et opposée à la première direction.
